(19) **Europäisches Patentamt**
**European Patent Office**
**Office européen des brevets**

(11) **EP 4 331 838 A1**

(12) **EUROPEAN PATENT APPLICATION**
published in accordance with Art. 153(4) EPC

(43) Date of publication:
**06.03.2024 Bulletin 2024/10**

(21) Application number: **22795538.2**

(22) Date of filing: **04.04.2022**

(51) International Patent Classification (IPC):
**B32B 27/00** (2006.01)    **H01L 41/193** (2006.01)
**B32B 7/025** (2019.01)    **C08J 7/00** (2006.01)

(52) Cooperative Patent Classification (CPC):
**B32B 7/025; B32B 27/00; C08J 7/00; H10N 30/857**

(86) International application number:
**PCT/JP2022/017048**

(87) International publication number:
**WO 2022/230622 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.04.2021 JP 2021076812**

(71) Applicant: **Kureha Corporation
Chuo-ku
Tokyo 103-8552 (JP)**

(72) Inventors:
• **OHISA, Shinji
Tokyo 103-8552 (JP)**
• **IMAJI, Makoto
Tokyo 103-8552 (JP)**

(74) Representative: **Zimmermann & Partner
Patentanwälte mbB
Postfach 330 920
80069 München (DE)**

(54) **PIEZOELECTRIC LAMINATED FILM AND METHOD FOR PRODUCING PIEZOELECTRIC LAMINATED FILM**

(57) Provided is a piezoelectric laminated film which does not discolor even under a high-temperature and high-humidity environment. The piezoelectric laminated film includes a piezoelectric film and a transparent adhesive sheet satisfying the following Condition 1. Condition 1: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 μg or less in terms of weight of 2,2'-azobis(isobutyronitrile).

EP 4 331 838 A1

**Description**

**[TECHNICAL FIELD]**

The present invention relates to a piezoelectric laminated film and a method for producing a piezoelectric laminated film.

**[BACKGROUND ART]**

A touch panel technique that allows to simultaneously perform position detection and press detection is attracting attention. As a means for conducting this technique, Patent Document 1 discloses an approach in which a capacitive position detection sensor known in the art and a press detection sensor including a piezoelectric film are laminated. As disclosed in Patent Document 2, a position detection sensor and a press detection sensor are laminated in which each layer is bonded with a transparent adhesive sheet.

[Citation List]

[Patent Document]

**[0003]**

　　　Patent Document 1: WO 2013/021835
　　　Patent Document 2: WO 2015/156196

**[SUMMARY OF INVENTION]**

[Technical Problem]

One of the applications of a touch panel is an in-vehicle touch panel. It is known that an electronic member of the in-vehicle touch panel is required to have high environmental resistance. For example, even when a touch panel is left to stand for a long time under a high-temperature and high-humidity environment of 85°C and 85% RH, it is required that the performance of the touch panel does not deteriorate and the touch panel operates normally.

However, as a result of studies conducted by the present inventors, it has been found that a laminate of a known position detection sensor and a press detection sensor including a piezoelectric film has an issue in that color tone deteriorates under a high-temperature and high-humidity environment.

Accordingly, the present invention is directed to achieving a laminate including a position sensor and a press detection sensor in which color tone does not deteriorate under a high-temperature and high-humidity environment.

[Solution to Problem]

In order to solve the above issues, a piezoelectric laminated film according to an aspect of the present invention is a piezoelectric laminated film including a piezoelectric film and a transparent adhesive sheet, in which the transparent adhesive sheet is a transparent adhesive sheet satisfying the following Condition 1.

Condition 1: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

Furthermore, a method for producing a piezoelectric laminated film according to an aspect of the present invention is a method for producing a piezoelectric laminated film, the method including a preparation step of preparing a transparent adhesive sheet satisfying the following Condition 1, and a lamination step of laminating the transparent adhesive sheet satisfying Condition 1 and a piezoelectric film.

Condition 1: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

[Advantageous Effects of Invention]

According to one aspect of the present invention, it is possible to achieve a laminate including a position sensor and a press detection sensor in which color tone does not deteriorate under a high-temperature and high-humidity environment.

[Description of Embodiments]

One embodiment of the present invention will be described in detail below.

1. Piezoelectric Laminated Film

A piezoelectric laminated film according to one embodiment of the present invention includes a piezoelectric film and a transparent adhesive sheet, and the transparent adhesive sheet satisfies the following Condition 1:

Condition 1: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

The "piezoelectric film" means a film having piezoelectric properties. The transparent adhesive sheet is not particularly limited, but may be, for example, a sheet material having an optical characteristic of transmitting 90% or more of visible light and further having adhesiveness. As the transparent adhesive sheet, a commercially available one may be used, which will be described below.

Detailed conditions such as an apparatus used in Condition 1 may be appropriately changed as long as a similar measurement result is obtained.

In Condition 1, equipment for performing solid-phase microextraction is all for an autosampler. The fiber may be one coated with polydimethylsiloxane. A thickness of the coating is preferably 5 $\mu$m or greater, more preferably 10 $\mu$m or greater, even more preferably 50 $\mu$m or greater, and most preferably 80 $\mu$m or greater. Further, the thickness of the coating is most preferably 125 $\mu$m or less. When the thickness is within this range, volatile components of the transparent adhesive sheet can be detected. For example, the thickness of the coating may be 100 $\mu$m.

A length of the coated portion of the fiber is preferably 0.5 cm or longer, and more preferably 1 cm or longer. In addition, the length of the coated portion is preferably 3 cm or less, and more preferably 2 cm or less. When the length of the coated portion of the fiber is within this range, measurement with sufficient detection sensitivity can be performed.

In Condition 1, a holder for performing solid-phase microextraction only needs to be one for an autosampler into which the fiber described above can be inserted.

The gas chromatography mass spectrometer is not particularly limited as long as it is compatible with solid-phase microextraction. Examples of the gas chromatography mass spectrometer include GC7890A/MS5975C available from Agilent Technologies, QP2020 available from Shimadzu Corporation, and JMS-1500GC available from JEOL Ltd.

A column used in the gas chromatograph is not particularly limited as long as it is a medium polar capillary column.

An ionization method used for mass spectrometry is an electron ionization (EI) method.

2,2'-azobis(isobutyronitrile) is a component widely contained in transparent adhesive sheets. When weight conversion of 2,2'-azobis(isobutyronitrile) contained in the transparent adhesive sheets is used, it is possible to evaluate a wide range of transparent adhesive sheets.

As a result of studies, the present inventors have found that when a piezoelectric film is exposed to volatile components of a transparent adhesive sheet under a high-temperature and high-humidity environment, the volatile components react with the piezoelectric film to cause a change in color tone of the piezoelectric film. When the transparent adhesive sheet satisfying the above Condition 1 is used for the piezoelectric laminated film, the amount of volatile components under a high-temperature and high-humidity environment can be reduced to an extremely small amount, and thus the change in color tone of the piezoelectric film under a high-temperature and high-humidity environment can be suppressed. Note that the color tone of the piezoelectric laminated film can be evaluated by an a* value, a b* value, and an L* value.

When the total amount of organic substances detected after a retention time of 3 minutes is 30 $\mu$g or less and more preferably 10 $\mu$g or less in terms of weight of 2,2'-azobis(isobutyronitrile) in the same analysis as the above Condition 1, the change in color tone of the piezoelectric film can be suitably suppressed.

Examples of the volatile components of the transparent adhesive sheet that change the color tone of the piezoelectric film include an organic substance. Examples of the organic substance include an acidic compound, a basic compound, and a silane coupling agent, which will be described below.

In the piezoelectric laminated film according to one embodiment of the present invention, the transparent adhesive sheet may be a transparent adhesive sheet further satisfying the following Condition 2.

Condition 2: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 μg in terms of weight of 2,2'-azobis(isobutyronitrile).

Examples of the volatile components of the transparent adhesive sheet that can cause a change in color tone of the film include a base and a silane coupling agent. It is preferable to use a transparent adhesive sheet satisfying the above Condition 2 because the amounts of these components can be limited.

The amounts of the components belonging to the base and the silane coupling agent detected after a retention time of 3 minutes when the same analysis as the above Condition 2 is performed is preferably 15 μg or less, more preferably 10 μg or less, and still more preferably 5 μg or less in terms of weight of 2,2'-azobis(isobutyronitrile). When the amount of the component belonging to the base or the silane coupling agent is within this range, it is possible to suitably suppress the change in color tone of the piezoelectric film.

In the piezoelectric laminated film according to one embodiment of the present invention, the transparent adhesive sheet may further satisfy the following Condition 3:

Condition 3: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of a component belonging to an acidic compound detected after a retention time of 3 minutes is less than 20 μg in terms of weight of 2,2'-azobis(isobutyronitrile).

The amount of the component belonging to the acidic compound detected after a retention time of 3 minutes when the same analysis as the above Condition 3 is performed is preferably 15 μg or less, more preferably 10 μg or less, and still more preferably 5 μg or less in terms of weight of 2,2'-azobis(isobutyronitrile). When the amount of the component belonging to the acidic compound is within this range, it is possible to suitably suppress the change in color tone of the piezoelectric film.

The acidic compound volatilized from the transparent adhesive sheet may be evaluated by a method other than the evaluation method described above. For example, an acid value of the volatile component may be evaluated by a method in accordance with JIS K0070-1992.

Note that in Conditions 1 to 3, the amount of the volatile components to be measured are preferably as small as possible because the change in color tone of the piezoelectric film can be suppressed.

Examples of the volatile components of the transparent adhesive sheet include an acidic compound, a basic compound, and a silane coupling agent. Specific examples of the volatile components of the transparent adhesive sheet are exemplified below, but compounds other than the compounds exemplified below are also included as the volatile components as long as they are detected as the volatile components of the transparent adhesive sheet in the detection method described in the above Condition 1, Condition 2, and Condition 3.

Examples of the acidic compound include an unsaturated carboxylic acid compound and an unsaturated dicarboxylic acid compound. More specific examples thereof include acrylic acid, methacrylic acid, maleic acid, and fumaric acid.

Examples of the basic compound include an amide compound, an amino compound, a hydroxy group-containing amino compound, and a hydroxy group-containing amide compound. More specific examples include N-methyl-2-pyrrolidone, N-vinyl-2-pyrrolidone, imidazole, N,N-dimethylacrylamide, 2-(dimethylamino) ethyl acrylate, N-methylolacrylamide, and N,N,N',N'-tetrakis(2-hydroxypropyl) ethylenediamine.

The silane coupling agent is a compound in which a hydrolyzable group and a reactive functional group are bonded to a silicon atom. A hydrolyzable group of the silane coupling agent is not particularly limited, and its examples include a methoxy group, an ethoxy group, and a dialkoxy group. In addition, a reactive functional group of the silane coupling agent is not particularly limited, and its examples include a vinyl group, an epoxy group, a styryl group, a methacryl group, an acryl group, an amino group, an isocyanurate group, a ureido group, a mercapto group, and an isocyanate group. The combination of the hydrolyzable group and the reactive functional group of the silane coupling agent is not particularly limited.

Examples of such a silane coupling agent include those described in JP 2020-143242 A. Typical examples include 3-glycidyloxypropyltrimethoxysilane, and trimethoxy[2-(7-oxabicyclo[4.1.0]hept-3-yl) ethyl] silane.

Transparent Adhesive Sheet

A type and a production method of the transparent adhesive sheet are not particularly limited as long as the transparent adhesive sheet satisfies Condition 1 or both Conditions 1 and 2 described above and has a function of bonding layers to each other as the transparent adhesive sheet. The transparent adhesive sheet may be formed by applying an adhesive on both surfaces of a base material, or may be formed only of an adhesive layer as a baseless transparent adhesive sheet including no base material. From the viewpoint of thinning, a baseless transparent adhesive sheet is more preferable. A thickness of the transparent adhesive sheet is preferably 5 $\mu$m or greater and further preferably 10 $\mu$m or greater. When the thickness of the transparent adhesive sheet is smaller than this range, there arises a problem in step followability. Furthermore, the thickness of the transparent adhesive sheet is preferably 2000 $\mu$m or less, more preferably 125 $\mu$m or less, even more preferably 80 $\mu$m or less, and particularly preferably 50 $\mu$m or less. When the thickness of the transparent adhesive sheet is greater than this range, sensitivity as a touch panel is lowered.

For example, a commercially available transparent adhesive sheet may be used. Note that even a commercially available transparent adhesive sheet that does not satisfy Condition 1 or satisfies neither Conditions 1 nor 2 described above may be used after performing a preparation step of preparing a transparent adhesive sheet that satisfies the conditions by performing an arbitrary treatment. Details of the preparation step of the transparent adhesive sheet will be described below in 2. Method for Producing Piezoelectric Laminated Film.

A material for the transparent adhesive sheet can be selected from all materials that can be used for transparent laminated films. The material may be an inorganic material or an organic material, and one or more kinds thereof may be used. Examples of the material include an acrylic resin-based adhesive agent, a rubber-based adhesive agent, a silicone-based adhesive agent, a polyester-based adhesive agent, a polyurethane-based adhesive agent, a polyamide-based adhesive agent, an epoxy resin-based adhesive agent, a polyvinyl alkyl ether-based adhesive agent, and a fluororesin-based adhesive agent. Among them, the acrylic resin-based adhesive agent is excellent from the viewpoint of cost effectiveness and thinning.

Piezoelectric Film

A type of the piezoelectric film is not particularly limited. Examples thereof include a film containing, as a main component, any one of a fluororesin; a vinylidene cyanide-based polymer; an odd-numbered nylon such as nylon 9 or nylon 11; a helical chiral polymer such as polylactic acid; a polyhydroxycarboxylic acid such as polyhydroxybutyrate; a cellulose-based derivative; polyurea; and a mixture of a ceramic-based piezoelectric material and a resin.

In particular, the piezoelectric film may contain a fluororesin as a main component. Note that "containing as a main component" means that a content of any resin contained in a composition of the piezoelectric resin may be 51 mass% or more, 80 mass% or more, or 100 mass%.

The fluororesin may be any fluororesin that can be used in a piezoelectric film, and may be one kind of fluororesin or multiple kinds of fluororesin. Examples of the fluororesin include a vinylidene fluoride resin, a tetrafluoroethylene resin, and a mixture thereof.

Examples of the vinylidene fluoride resin include a homopolymer of vinylidene fluoride and a copolymer thereof. A content of a structural unit derived from a monomer other than vinylidene fluoride in the copolymer of vinylidene fluoride may be appropriately determined within a range where characteristics according to the use of the piezoelectric laminated film can be expressed.

Examples of the monomer other than vinylidene fluoride in the copolymer of vinylidene fluoride include a hydrocarbon monomer and a fluorine compound. Examples of the hydrocarbon monomer include ethylene and propylene. The fluorine compound is a fluorine compound other than vinylidene fluoride and a fluorine compound having a polymerizable structure. Examples of the fluorine compound include vinyl fluoride, trifluoroethylene, trifluorochloroethylene, tetrafluoroethylene, hexafluoropropylene, and fluoroalkyl vinyl ethers.

Examples of the tetrafluoroethylene resin include a homopolymer of tetrafluoroethylene and a copolymer thereof. Examples of a monomer other than tetrafluoroethylene constituting a structural unit of the copolymer include ethylene, fluoropropylene, fluoroalkyl vinyl ether, perfluoroalkyl vinyl ether, and perfluorodioxole.

The piezoelectric film in the present embodiments may contain various additives within a range where the effect of the present embodiments can be achieved. The additive may be one kind of additive or multiple kinds of additives, and examples thereof include a plasticizer, a lubricant, a crosslinking agent, an ultraviolet absorber, a pH controlling agent, a stabilizer, an antioxidant, a surfactant, and a pigment.

A thickness of the piezoelectric film is preferably 5 $\mu$m or more, more preferably 20 $\mu$m or more, and still more preferably 30 $\mu$m or more from the viewpoint of achieving sufficient piezoelectric properties and mechanical strength. Furthermore, the thickness of the piezoelectric film is preferably 200 $\mu$m or less, more preferably 120 $\mu$m or less, and still more preferably 80 $\mu$m or less from the viewpoint of achieving sufficient transparency and piezoelectric properties. Note that a thickness of a laminated film can be determined by a known method, for example, by observing a cross section of the laminated film.

The piezoelectric characteristics of the piezoelectric film in the present embodiments can be appropriately set from a range in which the effects of the present embodiments can be achieved, according to the application of the piezoelectric laminated film. When the piezoelectric characteristics of the piezoelectric laminated film are too low, functionality as a piezoelectric material may be insufficient. From the viewpoint of achieving sufficient piezoelectric characteristics, in a case where the piezoelectric laminated film is used for a touch panel, for example, the piezoelectric characteristics of the piezoelectric film have a piezoelectric constant $d_{33}$ of preferably 6 pC/N or more, more preferably 10 pC/N or more, and even more preferably 12 pC/N or more. The upper limit of the piezoelectric characteristics is not limited, but in the above case, the piezoelectric constant $d_{33}$ may be 30 pC/N or less from the viewpoint of sufficiently obtaining the desired effect.

The piezoelectric film containing a fluororesin as a main component reacts with the volatile components of the transparent adhesive sheet to get discolored. However, when the transparent adhesive sheet satisfying Condition 1 or both Condition 1 and Condition 2 described above is used, it is possible to obtain an effect that even the piezoelectric film containing the fluororesin as a main component does not get discolored. Note that in a case of using a piezoelectric film containing a fluororesin as a main component, discoloration caused by the reaction with the volatile components is mainly yellowing.

Layer Configuration of Piezoelectric Laminated Film

The piezoelectric laminated film may have an optional layer different from the piezoelectric film and the transparent adhesive sheet. For example, it may have a transparent conductive layer, a transparent coating layer, a transparent base material, or the like. Note that a material, a thickness, the number, and the like of layers to be optionally added are not particularly limited as long as they are in ranges suitable for use in the piezoelectric laminated film.

The transparent conductive layer may be a layer having a structure which is also referred to as a so-called transparent electrode, has a planar spread, and has conductivity. The transparent conductive layer is a layer having a thickness of approximately 10 nm or greater and less than 45 nm. A form of the transparent conductive layer is not particularly limited, and may be a nanowire, a mesh, or a thin film. The thin film may have a single-layer structure or a stacked-layer structure including a plurality of layers.

A material forming the transparent conductive layer is not particularly limited, and a metal oxide of at least one metal selected from the group consisting of In, Sn, Zn, Ga, Sb, Ti, Si, Zr, Mg, Al, Au, Ag, Cu, Pd, and W is suitably used. The metal oxide may further contain a metal atom selected from the group described above, if necessary. As the metal oxide, ITO, antimony-tin composite oxide (ATO), or the like is preferably used, and ITO is particularly preferably used. Examples of other representative materials for the transparent conductive layer include a silver nanowire, a silver mesh, a copper mesh, graphene, and a carbon nanotube.

Examples of the transparent coating layer include a hard coat layer, an optical adjustment layer, an undercoat layer, an antiglare layer, and an antireflection layer. The transparent coating layer may be a single layer of these or a plurality of layers in combination thereof.

The hard coat layer refers to a transparent piezoelectric film protective layer for preventing scratches on the surface of the piezoelectric film, which is widely used in piezoelectric laminated films. The hard coat layer is a layer having a thickness of approximately 0.2 $\mu$m or greater and 3 $\mu$m or less.

A material for the transparent coating layer is not particularly limited, but may be an inorganic material or an organic material, and one or more kinds thereof may be used. Further, the material for the coating layer may be a material for the hard coat layer. Examples of the material include a melamine resin, a urethane resin, a (meth)acrylic acid ester resin, an epoxy resin, a phenoxy-based resin, a melamine-based resin, a silane compound, and a metal oxide. Note that the "(meth)acrylic acid ester" is a generic term for acrylic acid ester and methacrylic acid ester, and means one or both of them.

The transparent coating layer may have various functions within a range in which the effect of the present embodiments is achieved. The material for the transparent coating layer may further contain a material for achieving an optional function as another component. Examples of such materials include an optical modifier for controlling a refractive index of the transparent coating layer, an antistatic agent, a silane coupling agent, and an anti-blocking agent. Examples of the optical modifier include inorganic particles and polymer beads such as hollow silica-based fine particles, silicon oxide, aluminum oxide, titanium oxide, zirconium oxide, zinc oxide, and tin oxide. Examples of the antistatic agent include a surfactant, antimony pentoxide, indium tin oxide, and a conductive polymer.

The transparent base material may be provided as the outermost layer of the piezoelectric laminated film from the viewpoint of protecting the surface of the piezoelectric laminated film. The transparent base material is not particularly limited as long as it is a transparent base material similar to a general optical film, which can protect the surface of the piezoelectric laminated film. Examples of the material for such a transparent base material include transparent materials such as glass, polyethylene terephthalate, cycloolefin polymer, and polycarbonate. Note that the transparent base material may contain any one of these materials or a mixture of two or more of these materials.

In addition to the layer configuration described above, a layer for improving the optical characteristics of the piezoelectric laminated film may be additionally included as another layer configuration. For example, an antiglare layer or an antireflection layer may be included.

A layer having a protective function may be additionally included. For example, a known antifouling (fingerprint-resistant) layer, a protective film layer, or the like may be included.

The order of laminating layers is not particularly limited. The piezoelectric film and the transparent adhesive sheet may be directly bonded to each other. Examples of such a piezoelectric laminated film include a piezoelectric laminated film in which a transparent adhesive sheet and a protective film are stacked in this order on both surfaces of a piezoelectric film.

Further, another layer may be interposed between the piezoelectric laminated film and the transparent adhesive sheet. For example, a transparent coating layer may be provided between the piezoelectric film and the transparent adhesive sheet. Examples of such a piezoelectric laminated film include a piezoelectric laminated film in which a transparent coating layer, the transparent adhesive sheet, and a protective film are laminated in this order on both surfaces of the piezoelectric film. Note that even when another layer is present between the piezoelectric film and the transparent adhesive sheet, a change in color tone due to volatile substances may occur. Accordingly, even in a case where the piezoelectric film and the transparent adhesive sheet are laminated with another layer interposed therebetween, it is possible to suppress a change in color tone at a high temperature by using the transparent adhesive sheet satisfying Condition 1 or both Condition 1 and Condition 2 described above.

Physical Properties of Piezoelectric Laminated Film

The piezoelectric laminated film of the present embodiments undergoes little change in color tone even when exposed to a high-temperature and high-humidity environment for a long period of time. Here, the color tone of the piezoelectric laminated film can be evaluated using an L*a*b* color system. To be more specific, an L* value, an a* value, and a b* value can be measured by a method in accordance with JIS Z8722 using a spectrocolorimeter (SE7700 available from Nippon Denshoku Industries Co., Ltd.). In addition, $\Delta E$ indicating a change in color tone can be obtained by the following equation.

[Math. 1]

$$\Delta E = \sqrt{(\Delta L^*)^2 + (\Delta a^*)^2 + (\Delta b^*)^2}^{1/2}$$

Here, $\Delta L^*$, $\Delta a^*$, and $\Delta b^*$ are differences of the L* value, the a* value, and the b* value of the piezoelectric laminated film changed by the high-temperature and high-humidity environment, respectively.

The L* value of the piezoelectric laminated film is preferably 85 or more, and more preferably 90 or more. The a* value is preferably -1 or more and 1 or less, and more preferably -0.5 or more and 0.5 or less. The b* value may be - 5 or more and 5 or less, and is preferably -4 or more and 4 or less, more preferably -3 or more and 3 or less, still more preferably -2 or more and 2 or less, and particularly preferably -1 or more and 1 or less. When the L* value, the a* value, and the b* value are within these ranges, it can be determined that there is no problem in practical use in applications such as a touch panel. In particular, when the b* value does not exceed the upper limit, it can be determined that a yellow tint of the piezoelectric laminated film can be suppressed.

The value of $\Delta E$ indicating the change in color tone of the piezoelectric laminated film caused by being exposed to a high-temperature and high-humidity environment for a long period of time is preferably 5 or less, and more preferably 3 or less. When the change in color tone of the piezoelectric laminated film before and after exposure to the high-temperature and high-humidity environment is within the range, it can be determined that the change in color tone of the piezoelectric laminated film caused by the high-temperature and high-humidity environment is not observed.

The value of $\Delta b^*$ representing a change in the b* value of the piezoelectric laminated film caused by being exposed to a high-temperature and high-humidity environment for a long period of time is preferably 5 or less, more preferably 4 or less, and still more preferably 3 or less. In particular, in a piezoelectric laminated film having a b* value of -5 or more and 5 or less, when the value of $\Delta b^*$ of the piezoelectric laminated film before and after exposure to a high-temperature and high-humidity environment is within the range, it can be determined that yellowing of the piezoelectric laminated film caused by a high-temperature and high-humidity environment is not observed.

Note that the values of $\Delta E$ and $\Delta b^*$ are preferably as close to 0 as possible.

Here, exposure to a high-temperature and high-humidity environment for a long period of time means exposure to an environment at 85°C and 85% RH for 1000 hours, for example.

Application of Piezoelectric Laminated Film

The piezoelectric laminated film according to the present embodiments may be used for a touch panel. When the piezoelectric laminated film according to the present embodiments is used for a touch panel, it is possible to obtain a touch panel in which discoloration can be suppressed even under a high-temperature and high-humidity environment. In particular, it is possible to obtain a touch panel in which yellowing can be suitably suppressed.

The piezoelectric laminated film according to the present embodiments may be used in combination with an existing transparent electrode layer. The existing transparent electrode layer plays a role of a sensor for detecting a position, for example. The existing transparent electrode layer may be formed by laminating a transparent conductive layer on a film containing, as a material, any one or more of polyethylene terephthalate (PET), cycloolefin polymer (COP), polycarbonate (PC), and the like. Note that the transparent conductive layer included in the existing transparent electrode layer is not particularly limited, but may a layer similar to the transparent conductive layer described above.

2. Method for Producing Piezoelectric Laminated Film

A method for producing a piezoelectric laminated film according to one embodiment of the present invention includes a preparation step of preparing a transparent adhesive sheet satisfying the following Condition 1, and a lamination step of laminating the transparent adhesive sheet satisfying Condition 1 and a piezoelectric film.

Condition 1: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

In the method for producing a piezoelectric laminated film according to one embodiment of the present invention, the transparent adhesive sheet may be a transparent adhesive sheet further satisfying the following Condition 2.

Condition 2: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 $\mu$g in terms of weight of 2,2'-azobis(isobutyronitrile).

Preparation Step

In the preparation step, a transparent adhesive sheet satisfying the above Condition 1 or a transparent adhesive sheet satisfying both Condition 1 and Condition 2 is prepared. The preparation method is not limited. For example, in a case where a transparent adhesive sheet used for the piezoelectric laminated film satisfies Condition 1 or both Condition 1 and Condition 2 as a result of analysis, the transparent adhesive sheet can be used as it is for producing the piezoelectric laminated film.

In a case where a commercially available product is used, the transparent adhesive sheet is not particularly limited as long as it can be used as the transparent adhesive sheet of the piezoelectric laminated film. Examples thereof include, but are not limited to, LUCIACS CS986 series available from Nitto Denko Corporation ("LUCIACS" is a tradename of Nitto Denko Corporation), NNX series available from GUNZE LIMITED, SANCUARY available from San A Kaken Co., Ltd. ("SANCUARY" is a tradename of San A Kaken Co., Ltd.), PANACLEAN series available from Panac Co., Ltd. ("PANACLEAN" is a tradename of Panac Co., Ltd.), and Opteria series available from LINTEC Corporation ("Opteria" is a tradename of LINTEC Corporation).

Some commercially available transparent adhesive sheets do not satisfy Condition 1 or satisfy neither Condition 1 nor Condition 2 when they are untreated, although they can be used as the transparent adhesive sheet of the piezoelectric laminated film. Accordingly, in the preparation step, any treatment may be performed to obtain a transparent adhesive sheet satisfying Condition 1 or both Condition 1 and Condition 2.

Examples of the treatment for obtaining a transparent adhesive sheet satisfying Condition 1 and Condition 2 include heat treatment and washing treatment. Above all, it is preferable to perform heat treatment from the viewpoint of maintaining adhesiveness of the transparent adhesive sheet.

For example, in the preparation step, a transparent adhesive sheet that does not satisfy Condition 1 or satisfies neither Condition 1 nor Condition 2 may be heat-treated at 40°C to 135°C to volatilize volatile components contained in the transparent adhesive sheet, thereby obtaining a transparent adhesive sheet that satisfies the conditions described above. Note that, in the present specification, the wording "A to B" represents a range including numerical values on both ends (i.e., a range of A or greater and B or less).

A heat treatment temperature for volatilizing the volatile components contained in the transparent adhesive sheet is preferably 40°C to 135°C, and more preferably 60°C to 85°C. When the heat treatment temperature is not particularly lower than the lower limit, the volatile components can be sufficiently volatilized. When the heat treatment temperature does not exceed the upper limit, deformation of the transparent adhesive sheet can be prevented.

A time for heat treatment is not particularly limited as long as the volatile components contained in the transparent adhesive sheet can be volatilized. For example, the time for heat treatment is preferably 1 minute or longer, more preferably 3 minutes or longer, and even more preferably 5 minutes or longer. When the time for heat treatment is not shorter than the lower limit, the volatile components can be sufficiently volatilized. Furthermore, the time for heat treatment is preferably 24 hours or shorter, more preferably 12 hours or shorter, even more preferably 6 hours or shorter, and particularly preferably 1 hour or shorter. When the time for heat treatment does not exceed the upper limit, a time required for the preparation step can be shortened.

As such heat treatment, for example, heat treatment at 85°C for 24 hours may be performed.

When a transparent adhesive sheet that satisfies Condition 1 or both Condition 1 and Condition 2 is prepared in the preparation step, even a transparent adhesive sheet that does not satisfy Condition 1 or satisfies neither Condition 1 nor Condition 2 can be suitably used.

Lamination Step

The lamination step is not particularly limited as long as the piezoelectric laminated film can be produced by laminating the transparent adhesive sheet and the piezoelectric film. Note that the transparent adhesive sheet and the piezoelectric film may be laminated to be in direct contact with each other or may be laminated with another layer interposed therebetween.

For example, the transparent adhesive sheet may be laminated on both surfaces of the piezoelectric film, and the transparent base material may be further laminated on both of the surfaces. Alternatively, for example, the transparent coating layer may be laminated on both surfaces of the piezoelectric film, the transparent adhesive sheet may be further laminated on both of the surfaces, and the transparent base material may be further laminated on both of the surfaces.

The layers only need to be laminated in accordance with a method known in the related art. The transparent adhesive sheet can be laminated by being bonded to the piezoelectric film. The transparent base material can be laminated by, for example, a laminator. The transparent coating layer can be laminated by being applied using, for example, a bar coater.

The present invention is not limited to the above-described embodiments, and various modifications can be made within the scope of the claims, and embodiments obtained by appropriately combining technical means disclosed in different embodiments are also included in the technical scope of the present invention.

Recapitulation

The present invention may be embodied as follows.

A piezoelectric laminated film according to a first aspect includes a piezoelectric film and a transparent adhesive sheet, and the transparent adhesive sheet is a transparent adhesive sheet satisfying the following Condition 1:

Condition 1: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

With this configuration, it is possible to obtain a piezoelectric laminated film in which color tone does not change even under a high-temperature and high-humidity environment.

A piezoelectric laminated film according to a second aspect is the piezoelectric laminated film according to the first aspect in which the transparent adhesive sheet further satisfies the following Condition 2: Condition 2: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 $\mu$g in terms of weight of 2,2'-azobis(isobutyronitrile).

With this configuration, it is possible to reduce an amount of a volatile substance derived from the transparent adhesive sheet that changes the color tone of the piezoelectric film under a high-temperature and high-humidity environment.

A piezoelectric laminated film according to a third aspect is the piezoelectric laminated film according to the first aspect in which the piezoelectric film contains a fluororesin as a main component.

A piezoelectric laminated film according to a fourth aspect is the piezoelectric laminated film according to the second aspect in which the piezoelectric film contains a fluororesin as a main component. In the third or fourth aspect, the amount of volatile component from the transparent adhesive sheet is small and thus, reaction with the fluororesin can be suppressed. This can prevent yellowing of the piezoelectric film.

A production method according to a fifth aspect is a method for producing a piezoelectric laminated film, the method including a preparation step of preparing a transparent adhesive sheet satisfying the following Condition 1, and a lamination step of laminating the transparent adhesive sheet satisfying Condition 1 and a piezoelectric film:

Condition 1: when volatile components obtained from a test piece per 1 $cm^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

With this configuration, it is possible to produce a piezoelectric laminated film in which color tone does not change even under a high-temperature and high-humidity environment.

A production method according to a sixth aspect is the production method according to claim 4 including a preparation step of preparing a transparent adhesive sheet satisfying the following Condition 2, and a lamination step of laminating the transparent adhesive sheet satisfying Condition 2 and a piezoelectric film, in the fifth aspect:
Condition 2: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 μg in terms of weight of 2,2'-azobis(isobutyronitrile).

With this configuration, it is possible to produce a piezoelectric laminated film in which color tone does not change under a high-temperature and high-humidity environment.

A production method according to a seventh aspect is the method for producing a piezoelectric laminated film according to the fifth aspect, in which in the preparation step, a transparent adhesive sheet that satisfies Condition 1 or both Condition 1 and Condition 2 is obtained by heat-treating a transparent adhesive sheet that does not satisfy Condition 1 or satisfies neither Condition 1 nor Condition 2 at 40°C to 135°C. With this configuration, even in a case of a transparent adhesive sheet containing a large amount of volatile components, the volatile components can be suppressed, and thus a transparent adhesive sheet preferable as a material for a piezoelectric laminated film can be prepared.

A production method according to an eighth aspect is the method for producing a piezoelectric laminated film according to the sixth aspect, in which in the preparation step, a transparent adhesive sheet that satisfies both Condition 1 and Condition 2 is obtained by heat-treating a transparent adhesive sheet that satisfies neither Condition 1 nor Condition 2 is heat-treated at 40°C to 135°C.

A touch panel according to an eighth aspect is a touch panel including the piezoelectric laminated film described in any one of the first to fourth aspects. With this configuration, it is possible to obtain a touch panel which does not get discolored even at a high temperature and a high humidity.

Examples

The present invention will be described more specifically below based on examples, but the present invention is not limited to these examples.

1. Production of Piezoelectric Laminated Film

Example 1

Preparation of Piezoelectric Film

Polyvinylidene fluoride (inherent viscosity 1.1 dl/g) was melt-molded into a sheet having a thickness of 140 μm and a width of 350 mm, which was then uniaxially stretched about 4.1 times to obtain a uniaxially stretched film. A direct-current voltage of 11.8 kV was applied to the uniaxially stretched film to perform polarization treatment, and then heat treatment was performed at 130°C for 40 seconds to obtain a piezoelectric film having a thickness of 40 μm.

Lamination of Transparent Adhesive Sheet

A commercially available baseless transparent adhesive sheet A (thickness of 25 μm) containing butyl acrylate as a main component of the adhesive was cut into an A4 size, one of release sheets attached to both surfaces of the sheet was peeled off, and the sheet was then bonded to one surface of the piezoelectric film at a pressure of 0.2 MPa using a Halder laminator (MRK-650Y type Halter laminator available from MCK Co., Ltd.). The same operation was performed on the other surface of the piezoelectric film to obtain a piezoelectric laminated film in which the transparent adhesive layer was formed on both surfaces of the piezoelectric film.

Example 2

Preparation of Piezoelectric Film

The same operation as in Example 1 was performed, and thus a piezoelectric film was obtained.

Heat Treatment of Transparent Adhesive Sheet

A commercially available baseless transparent adhesive sheet B (thickness of 50 $\mu$m) containing 2-hexylethyl acrylate as a main component of the adhesive was cut into an A4 size, one of release sheets attached to both surfaces was peeled off, and the sheet was then heated at 85°C for 24 hours in a gear oven (GPS-60H available from SHIMIZU SCIENTIFIC INSTRUMENTS MFG Co., Ltd.) to obtain a transparent adhesive sheet D.

Lamination of Transparent Adhesive Sheet D

The obtained transparent adhesive sheet D was bonded to a piezoelectric film in the same manner as in Example 1 to obtain a piezoelectric laminated film.

Example 3

Preparation of Piezoelectric Film

The same operation as in Example 1 was performed, and thus a piezoelectric film was obtained. An amorphous silica-containing ultraviolet curable resin composition (material) made of an acrylic resin was applied to both surfaces of the piezoelectric film, dried at 60°C, and then irradiated with ultraviolet rays to form a hard coat layer having a thickness of 1 $\mu$m, thereby preparing a piezoelectric film provided with the hard coat layer.

Lamination of Transparent Adhesive Sheet

The transparent adhesive sheet A was bonded to the piezoelectric film in the same manner as in Example 1 to obtain a piezoelectric laminated film.

Comparative Example 1

The same procedure as in Example 1 was performed except that the transparent adhesive sheet B was used instead of the transparent adhesive sheet A.

Comparative Example 2

The same procedure as in Example 1 was performed except that a commercially available baseless transparent adhesive sheet C (thickness of 75 $\mu$m) different from the transparent adhesive sheet B, in which the main component of the adhesive was 2-hexylethyl acrylate, was used instead of the transparent adhesive sheet A.

Piezoelectric Constant $d_{33}$

A piezoelectric constant $d_{33}$ of each of the laminated piezoelectric films of Examples 1 to 3 and Comparative Examples 1 and 2 was measured using a piezoelectric constant measuring device (Piezometer System PM300 available from PIEZOTEST Pte Ltd.). Measurement conditions of the piezoelectric constant are as follows.

Measurement Conditions of Piezoelectric Constant

. Static Force: 0.2 N
· Oscilatory Force: 0.15 N
· Frequency: 110 Hz
· Measurement Range: Low
· Probe: Small domed Electrode

Voltages ($d_{33}$) of the piezoelectric films used in the piezoelectric laminated films of Examples 1 to 3 and Comparative Examples 1 and 2, presence or absence of the transparent coating layer, and types of the transparent adhesive sheets are indicated in Table 1.

[Table 1]

|  | Piezoelectric film $d_{33}$ (pC/N) | Transparent coating layer | Type of transparent adhesive sheet |
|---|---|---|---|
| Example 1 | 22.2 | - | A |
| Example 2 | 17.8 | - | D |
| Example 3 | 14.6 | ○ | A |
| Comparative Example 1 | 17.5 | - | B |
| Comparative Example 2 | 17.8 | - | C |

2. Evaluation of Piezoelectric Laminated Film

High-temperature and High-humidity Environment Test

Each of the piezoelectric laminated films prepared in Examples 1 to 3 and Comparative Examples 1 and 2 was cut into a square having one side of 10 cm to obtain a test piece. The test piece was left to stand in a constant-temperature and constant-humidity chamber (ECONAS LH34-14M available from NAGANO SCIENCE Co., Ltd.) set at 85°C and 85% RH to perform a high-temperature and high-humidity environment test. The test piece was taken out after 1000 hours from start of the high-temperature and high-humidity environment test. The color tone of each test piece before and after the high-temperature and high-humidity environment test was measured under the following conditions, and change in color tone due to the high-temperature and high-humidity environment was evaluated.

Evaluation of Color Tone and Change in Color Tone

The color tone of the piezoelectric laminated film was evaluated using the L*a*b* color system. An L* value, an a* value, and a b* value were measured by a method in accordance with JIS Z8722 using a spectrocolorimeter (SE7700 available from Nippon Denshoku Industries Co., Ltd.). To be more specific, D65/10° was used as measurement light, and measurement was performed by a transmission method under a geometric condition (0° : 0°). ΔE representing a change in color tone was determined by the following equation.

[Math. 2]

$$\Delta E = \sqrt{(\Delta L^*)^2 + (\Delta a^*)^2 + (\Delta b^*)^2}^{1/2}$$

Here, ΔL*, Δa*, and Δb* are differences of the L* value, the a* value, and the b* value of the piezoelectric laminated film before and after the high-temperature high-humidity environment test, respectively.
Note that the L* value of the piezoelectric laminated film is preferably 85 or more, and more preferably 90 or more. The a* value is preferably -1 or more and 1 or less, and more preferably -0.5 or more and 0.5 or less. The b* value is preferably -5 or more and 5 or less, and more preferably -4 or more and 4 or less. When the L* value, the a* value, and the b* value are within the ranges, it can be determined that there is no problem in practical use in applications of devices such as a touch panel.
The change in color tone (ΔE) of the piezoelectric laminated film before and after the high-temperature and high-humidity environment test is preferably 5 or less, and more preferably 3 or less. When the value of ΔE is within this range, it can be determined that change in color tone of the piezoelectric laminated film is not observed.
In particular, a value of Δb* representing the change in b* value before and after the high-temperature and high-humidity environment test is preferably 5 or less, more preferably 4 or less, and even more preferably 3 or less. In the piezoelectric laminated film having a b* value of -5 or more and 5 or less, when the value of Δb* before and after the high-temperature and high-humidity environment test is within the range, it can be determined that yellowing of the piezoelectric laminated film due to the high-temperature and high-humidity environment is not observed.
The change in color tone of each test piece by the high-temperature and high-humidity environment test is indicated in the following Table 2. Note that the change in color tone of the test piece was all caused by the piezoelectric film and not by the transparent adhesive sheet.

[Table 2]

| | Color tone | | | | | | Amount of change in color tone at 85°C and 85% RH × after 1000 hr | |
|---|---|---|---|---|---|---|---|---|
| | 0 hr | | | After 1000 hr | | | ΔE | Δb* |
| | L* | a* | b* | L* | a* | b* | | |
| Example 1 | 93.1 | 0.0 | 1.9 | 92.4 | 0.0 | 2.4 | 0.9 | 0.5 |
| Example 2 | 90.9 | 0.0 | 2.9 | 91.1 | -0.1 | 3.8 | 0.9 | 0.9 |
| Example 3 | 92.9 | 0.1 | 2.1 | 92.0 | 0.0 | 2.5 | 1.0 | 0.4 |
| Comparative Example 1 | 91.0 | 0.0 | 2.9 | 88.1 | 0.5 | 10.4 | 8.1 | 7.6 |
| Comparative Example 2 | 90.9 | -0.3 | 3.0 | 84.7 | 2.8 | 17.9 | 15.0 | 16.5 |

Total Amount of Volatile Substances Generated from Transparent Adhesive Sheet

A total amount of volatile substances generated from each of the transparent adhesive sheets A to D in a high temperature environment was determined by solid-phase microextraction and gas chromatography mass spectrometry. Specifically, the total amount of volatile substances was determined as follows.

Release sheets on both surfaces of each of the transparent adhesive sheets A to D cut into a square having one side of 2.5 cm were removed, and each of the transparent adhesive sheets A to D was individually separated and attached to a lower part of an inner wall of a vial (Screw vials with flat top 20 ml Clear glass available from Gerstel), followed by plugging with a septum (silicone rubber/PTFE) and a screw cap. Then, after heating at 85°C for 30 minutes by an agitator attached to an autosampler (MultPurposeSampler MPS2 available from Gerstel), a fiber (PDMS available from Sigma-Aldrich Co. LLC; polydimethylsiloxane coating, thickness: 100 $\mu$m) of an SPME (solid-phase microextraction) method was inserted into the vial, and volatile substances were adsorbed onto the fiber while maintaining 85°C for 60 minutes. The fiber was inserted into an inlet of a gas chromatography mass spectrometer (GC7890A/MS5975C available from Agilent Technologies), heated at 250°C for 30 seconds to desorb the adsorbed volatile substances, which were measured under the following gas chromatograph mass spectrometry conditions to obtain a TIC (total ion chromatogram).

Gas Chromatograph Mass Spectrometry Conditions

Used apparatus

. GC/MS: GC7890A/MS5975C available from Agilent Technologies
· Autosampler: MultPurposeSampler MPS2 available from Gerstel
· Vial: Screw vials with flat top 20 ml Clear glass, for 18 mm-screw caps available from Gerstel
· Septum lid: septum (Sillicone/PTFE) Art. -Nr.: 093640-057-00 available from Gerstel

GC unit condition

. Column: TC-17 30 m × 250 $\mu$m × 0.25 $\mu$m available from GL Sciences Inc.
· Oven program: 40°C × 5 min - 20°C/min - 250°C × 10 min
· Injection method: splitless
· Heater temperature: 250°C,
· Column flow rate: 1 mL/min
· Carrier gas: He
· Purge flow rate to split vent: 50 mL/min Start time: 1 min
· Initial solvent removal time: 3 min

MS Condition

· Ionization method: EI
· Ion source temperature: 230°C
· Quadrupole temperature: 150°C

Furthermore, 2,2'-azobis(isobutyronitrile) (Wako special grade available from Fujifilm Wako Pure Chemical Industries, Ltd.) was used as a standard sample to prepare chloroform solutions having different concentrations, and 5 µL of each solution was weighed and measured for a gas chromatogram in the same manner as for the transparent adhesive sheet. A calibration curve was created from a peak area in the obtained TIC and the addition amount of 2,2'-azobis(isobutyronitrile), and from this calibration curve and a total peak area of the TIC of the transparent adhesive sheet, the total amount of volatile components generated from the transparent adhesive sheet was calculated in terms of 2,2'-azobis(isobutyronitrile). The total amount of the volatile substances thus obtained was divided by the surface area of the transparent adhesive sheet (6.25 cm$^2$) to obtain a weight of the volatile components per 1 cm$^2$. The weights of volatile components volatilized from the transparent adhesive sheets A to D are indicated in Table 3 below.

[Table 3]

| | Converted value (µg) by SPME GCMS | | | |
|---|---|---|---|---|
| | All organic compounds | Basic compound | Silane coupling agent | Acidic compound |
| Transparent adhesive sheet A | 6 | N.D. | N.D. | N.D. |
| Transparent adhesive sheet B | 144 | 13 | 32 | N.D. |
| Transparent adhesive sheet C | 52 | 13 | 7 | N.D. |
| Transparent adhesive sheet D | 4 | N.D. | N.D. | N.D. |
| N.D.: Not Detected | | | | |

Amount in Volatile Components Generated from Transparent Adhesive Sheet

An area was individually determined for each of peaks belonging to the basic substance and the silane coupling agent, and a weight was calculated in terms of 2,2'-azobis(isobutyronitrile) using the calibration curve obtained above. Note that in each sheet, compounds belonging to the basic substance and the silane coupling agent are indicated below.
Transparent adhesive sheet A: There was no compound belonging to the basic substance or the silane coupling agent.
Transparent adhesive sheet B: N-vinyl-2-pyrrolidone and 3-glycidyloxypropyltrimethoxysilane appearing at retention times of 11.71 minutes and 13.53 minutes, respectively, were belonging to the basic substance and the silane coupling agent, respectively, and calculated from the respective peak areas.
Transparent adhesive sheet C: Diacetoneacrylamide and trimethoxy[2-(7-oxabicyclo[4.1.0]hept-3-yl)ethyl] silane appearing at retention times of 12.57 minutes and 14.44 minutes, respectively, were belonging to the basic substance and the silane coupling agent, respectively, and calculated from the respective peak areas.
Transparent adhesive sheet D: No compound belonging to the basic substance or the silane coupling agent was observed.

3. Coloring of Piezoelectric Film by Volatile Substances in Transparent Adhesive Sheet

Experimental Example 1

Water (100 mL) was placed in a vial, 100 mmol of N-methyl-2-pyrrolidone was added thereto, and the mixture was stirred to obtain a uniform solution. A test piece of the piezoelectric film cut into a square having one side of 5 cm was immersed in the solution. Thereafter, the vial was covered with a lid and allowed to stand in an oven at 85°C to perform a high-temperature and high-humidity environment test. After 100 hours from the start of the high-temperature and high-humidity environment test, the color tone of the test piece was evaluated.

Experimental Example 2

A high-temperature and high-humidity environment test was performed in the same manner as in Experimental Example 1 except that N-methyl-2-pyrrolidone was not added to the vial.

Experimental Example 3

A high-temperature and high-humidity environment test was performed in the same manner as in Experimental Example 1, except that 100 mL of toluene was used instead of water that was placed in the vial and 3-glycidyloxypropyltrimethoxysilane was added to the solvent instead of N-methyl-2-pyrrolidone.

Experimental Example 4

A high-temperature and high-humidity environment test was performed in the same manner as in Experimental Example 3 except that 3-glycidyloxypropyltrimethoxysilane was not added to the vial.

Evaluation of Color Tone and Change in Color Tone

The L* values, the a* values, and the b* values of the test pieces after the high-temperature and high-humidity environment test in Experimental Examples 1 to 4 were measured in the same manner as in the evaluation of the color tone and the change in color tone of the piezoelectric film described in 2. Evaluation of Piezoelectric Laminated Film. Note that the L* value of the piezoelectric film before being immersed in the various solutions was 96.6, the a* value was 0.1, and the b* value was 0.8. The measurement results of the color tones and the changes in color tone of the piezoelectric films are indicated in the following Table 4.

[Table 4]

|  | Solvent | Added compound | Color tone (After 100 hr) | | | Change in color tone | |
|---|---|---|---|---|---|---|---|
|  |  |  | L* | a* | b* | Δb* | ΔE |
| Experimental Example 1 | Water | N-Methyl-2-pyrrolidone | 95.8 | 0.1 | 3.6 | 2.8 | 7.0 |
| Experimental Example 2 | Water | - | 96.5 | 0.1 | 0.8 | 0.1 | 0.1 |
| Experimental Example 3 | Toluene | 3-Glycidyloxypropyltrimethoxysilane | 95.9 | 0.0 | 3.5 | 2.77 | 2.9 |
| Experimental Example 4 | Toluene | - | 96.7 | 0.0 | 0.7 | -0.1 | 0.2 |

From Table 4, it was found that the piezoelectric film to which the volatile substances and the similar compound in the transparent adhesive sheet were added was yellowed by the high-temperature and high-humidity environment test.

[Industrial Applicability]

The present invention can be used for a touch panel or the like.

**Claims**

1. A piezoelectric laminated film comprising a piezoelectric film and a transparent adhesive sheet, the transparent adhesive sheet being a transparent adhesive sheet satisfying the following Condition 1:
Condition 1: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 μg or less in terms of weight of 2,2'-azobis(isobutyronitrile).

2. The piezoelectric laminated film according to claim 1, wherein the transparent adhesive sheet is a transparent adhesive sheet further satisfying the following Condition 2:
Condition 2: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 $\mu$g in terms of weight of 2,2'-azobis(isobutyronitrile).

3. The piezoelectric laminated film according to claim 1, wherein the piezoelectric film contains a fluororesin as a main component.

4. The piezoelectric laminated film according to claim 2, wherein the piezoelectric film contains a fluororesin as a main component.

5. A method for producing a piezoelectric laminated film, the method comprising: a preparation step of preparing a transparent adhesive sheet satisfying the following Condition 1; and a lamination step of laminating the transparent adhesive sheet satisfying Condition 1 and a piezoelectric film:
Condition 1: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, a total amount of organic substances detected after a retention time of 3 minutes is 50 $\mu$g or less in terms of weight of 2,2'-azobis(isobutyronitrile).

6. The method for producing a piezoelectric laminated film according to claim 5, wherein the transparent adhesive sheet is a transparent adhesive sheet further satisfying the following Condition 2:
Condition 2: when volatile components obtained from a test piece per 1 cm$^2$ that has been held at 85°C for 90 minutes are subjected to solid-phase microextraction, adsorbed onto a fiber coated with polydimethylsiloxane, and analyzed by a gas chromatography mass spectrometer, an amount of components belonging to a base and a silane coupling agent detected after a retention time of 3 minutes is less than 15 $\mu$g in terms of weight of 2,2'-azobis(isobutyronitrile).

7. The method for producing a piezoelectric laminated film according to claim 5, wherein in the preparation step, a transparent adhesive sheet that satisfies Condition 1 is obtained by heat-treating a transparent adhesive sheet that does not satisfy Condition 1 at 40°C to 135°C.

8. The method for producing a piezoelectric laminated film according to claim 6, wherein in the preparation step, a transparent adhesive sheet that satisfies both Condition 1 and Condition 2 is obtained by heat-treating a transparent adhesive sheet that satisfies neither Condition 1 nor Condition 2 at 40°C to 135°C.

9. A touch panel comprising the piezoelectric laminated film described in any one of claims 1 to 4.

## INTERNATIONAL SEARCH REPORT

| International application No. |
| --- |
| **PCT/JP2022/017048** |

| A. | CLASSIFICATION OF SUBJECT MATTER |
| --- | --- |

*B32B 27/00*(2006.01)i; *H01L 41/193*(2006.01)i; *B32B 7/025*(2019.01)i; *C08J 7/00*(2006.01)i
FI: H01L41/193; B32B7/025; C08J7/00 301; B32B27/00 M; C08J7/00 CEZ

According to International Patent Classification (IPC) or to both national classification and IPC

| B. | FIELDS SEARCHED |
| --- | --- |

Minimum documentation searched (classification system followed by classification symbols)

B32B27/00; H01L41/193; B32B7/025; C08J7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2016/093120 A1 (NITTO DENKO CORP.) 16 June 2016 (2016-06-16) | 1, 2, 5, 6, 9 |
|  | paragraphs [0010]-[0064], fig. 1 |  |
| Y |  | 3, 4, 7, 8 |
| Y | WO 2015/064328 A1 (DAIKIN INDUSTRIES, LTD.) 07 May 2015 (2015-05-07) | 3, 4 |
|  | paragraph [0024] |  |
| Y | JP 2017-105878 A (DIC CORP.) 15 June 2017 (2017-06-15) | 7, 8 |
|  | paragraphs [0116]-[0120] |  |
| A | JP 2015-075968 A (DAIKIN INDUSTRIES, LTD.) 20 April 2015 (2015-04-20) | 1-9 |
|  | paragraphs [0014]-[0035], fig. 1, 2 |  |

| ☐ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 June 2022** | **28 June 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** |  |
|  | Telephone No. |

Form PCT/ISA/210 (second sheet) (January 2015)

**INTERNATIONAL SEARCH REPORT**
**Information on patent family members**

International application No.

**PCT/JP2022/017048**

| Patent document cited in search report | | | Publication date (day/month/year) | Patent family member(s) | | | Publication date (day/month/year) |
|---|---|---|---|---|---|---|---|
| WO | 2016/093120 | A1 | 16 June 2016 | JP | 2016-110995 | A | |
| | | | | TW | 201627151 | A | |
| WO | 2015/064328 | A1 | 07 May 2015 | JP | 2019-110307 | A | |
| JP | 2017-105878 | A | 15 June 2017 | (Family: none) | | | |
| JP | 2015-075968 | A | 20 April 2015 | (Family: none) | | | |

Form PCT/ISA/210 (patent family annex) (January 2015)

**EP 4 331 838 A1**

REFERENCES CITED IN THE DESCRIPTION

**Patent documents cited in the description**

- WO 2013021835 A
- WO 2015156196 A
- JP 2020143242 A